Europäisches Patentamt

(19) European Patent Office

Office européen des brevets

(11) Numéro de publication: **0 125 968**
**A1**

(12) **DEMANDE DE BREVET EUROPEEN**

(21) Numéro de dépôt: 84400875.5

(22) Date de dépôt: 02.05.84

(51) Int. Cl.³: **H 01 L 29/08**
**H 01 L 29/52**

(30) Priorité: 03.05.83 FR 8307342

(43) Date de publication de la demande:
21.11.84 Bulletin 84/47

(84) Etats contractants désignés:
DE FR GB IT NL SE

(71) Demandeur: FAIRCHILD CAMERA & INSTRUMENT
CORPORATION
464 Ellis Street
Mountain View California 94042(US)

(72) Inventeur: Rossetti, Pierre
12, Chemin Renaudin
F-92260 Fontenay aux Roses(FR)

(74) Mandataire: Chareyron, Lucien et al,
Schlumberger Limited Service Brevets c/o Giers, B.P. 121
12, place des Etats-Unis
F-92124 Montrouge Cedex(FR)

(54) Composant semi-conducteur de puissance, et procédé pour sa fabrication.

(57) Ce semi-conducteur est du type multicellulaire, qui présente, en surface d'un substrat (10) une pluralité de zones diffusées et de zones d'émergence du substrat ordonnées les unes par rapport aux autres en un réseau de cellules alternativement de types N et P, les cellules de chaque type étant toutes reliées en parallèle pour définir une des bornes du composant.

Selon l'invention, deux nappes conductrices (30, 50) recouvrent l'ensemble du réseau et assurent la mise en parallèle de toutes les cellules d'un même type.

Ces deux nappes s'interpénètrent dans une zone frontière (ZF), de manière que chacune des demi-nappes supérieure soit reliée à la demi-nappe inférieure située de l'autre côté de cette zone frontière.

En surface, le composant présente deux grandes plages (50e, 50b) reliées chacune à toutes les cellules d'un même type, et correspondant respectivement à l'électrode d'émetteur (ou de cathode) et à l'électrode de base (ou de gâchette) du composant.

FIG_14

EP 0 125 968 A1

COMPOSANT SEMI-CONDUCTEUR DE PUISSANCE,

ET PROCEDE POUR SA FABRICATION

La présente invention concerne un composant semi-conducteur de puissance, ainsi qu'un procédé pour sa fabrication.

Les semi-conducteurs de puissance, qu'ils soient utilisés en commutation ou en amplification, doivent permettre la conduction de forts courants ; ceci pose des problèmes particuliers tant en ce qui concerne la structure même du composant (il y a lieu de limiter la densité de courant à l'intérieur des matériaux semi-conducteurs à des valeurs admissibles) que la manière dont sont réalisées les prises de contacts sur les différentes zones semi-conductrices (il est notamment nécessaire de réduire au minimum les chutes de tension dues à ces contacts).

Ces deux impératifs sont en général contradictoires dans les semi-conducteurs de puissance : en effet, dans ces derniers, la largeur de l'électrode diffusée en surface du substrat (c'est-à-dire l'émetteur, si l'on prend comme exemple de semi-conducteur de puissance un transistor du type planar) doit être relativement réduite, car seul le bord de la zone diffusée conduit le courant. Pour limiter la densité locale de courant dans la jonction, on donne au composant une structure dite "interdigitée", c'est-à-dire que l'émetteur - qui reste d'un seul tenant - présente une structure ramifiée pour accroître son périmètre. La prise de contact est réalisée en un ou plusieurs points de l'émetteur.

Du fait de la liaison unique par l'émetteur ramifié, l'arrivée de courant aux extrémités les plus éloignées de la prise de contact se fait mal en raison des chutes de tension le long des différentes ramifications. Il en résulte une densité de courant très inégale entre les zones d'émetteur situées près de la prise de connexion et celles qui en sont éloignées. Ce manque d'homogénéité . croît très vite avec la puissance pour laquelle est prévu le semi-conducteur : en effet, l'accroissement de puissance nécessite à la fois une augmentation des dimensions du composant et une interdigitation plus compliquée pour mieux couvrir la surface accrue de celui-ci ; la complexité de la structure et les chutes de tension importantes limitent alors très rapidement les performances en puissance de ces structures à émetteur ramifié.

Pour pallier cet inconvénient, il a été proposé de diviser l'émetteur au lieu de le ramifier.

Dans cette structure de semi-conducteur (connue sous le nom de structure multicellulaire ), une pluralité de zones de type N ou P sont diffusées à la surface du substrat de type respectivement P ou N de manière à présenter, en surface de celui-ci, une pluralité de zones diffusées et de zones d'émergence du substrat ordonnées les unes par rapport aux autres pour former un réseau de cellules alternativement de types N et P. Les cellules de chaque type sont toutes reliées entre elles et à un conducteur commun définissant l'une des bornes du composant.

Les performances des semi-conducteurs de ce type sont supérieures à celles des semi-conducteurs à émetteur ramifié, tant en ce qui concerne la tension maximale admissible, le gain, la fréquence de coupure, la densité de courant dans les cellules, que le produit courant x tension à l'ouverture.

La difficulté se reporte par contre sur la manière de réaliser les prises de contact, car il convient d'une part de relier ensemble toutes les cellules d'un même type (l'électrode n'étant plus, comme précédemment, d'un seul tenant) et d'autre part de prévoir deux séries de liaisons (l'une pour les émetteurs, l'autre pour les bases) au lieu d'une.

Pour cela, il a été proposé de placer sur le substrat deux conducteurs adjacents aux cellules, qui sont disposées à la manière d'îlots le long des conducteurs, mais sont isolées de ceux-ci ; chacun de ces îlots est ensuite raccordé au conducteur commun correspondant par un pont conducteur.

Cette structure, grâce à la mise en parallèle des différentes cellules, permet d'atteindre les performances en tension, fréquence, ..... attendues. Elle conserve cependant l'inconvénient, précédemment exposé à propos des structures à émetteur ramifié, d'une mauvaise amenée de courant, surtout aux cellules les plus éloignées.

En outre, la perte de surface sur le substrat est importante en raison des deux conducteurs communs qui doivent courir le long de toutes les cellules (et l'allongement de ces conducteurs va à l'encontre de la réduction souhaitée des chutes de tension). Il devient impossible de faire des composants de haute densité ou de multiplier le nombre des cellules (et donc d'accroître la puissance) sans atteindre des dimensions prohibitives ni limiter la fréquence de coupure.

Un des buts de l'invention est d'apporter une solution à ce problème, en proposant une structure de semiconducteur du type multicellulaire dans lequel les cellules de l'un et l'autre type sont reliées ensemble avec le moins de perte de surface possible, ainsi qu'avec une amenée de courant parfaitement homogène à toutes les cellules du réseau.

A cette fin, le composant selon l'invention comprend :

- une nappe conductrice inférieure formant un premier conducteur commun, s'étendant au-dessus de la surface du substrat et isolée de celui-ci à l'exception de ponts reliant cette nappe à chacune des cellules d'un premier type, N ou P,

- une nappe conductrice supérieure formant un second conducteur commun, s'étendant au-dessus de la nappe inférieure et isolée de celle-ci, cette nappe supérieure étant reliée à chacune des cellules du second type, P ou N respectivement, au moyen de ponts conducteurs traversant, au droit de chacune des cellules, la nappe inférieure en restant isolés de cette nappe et sans solution de continuité électrique de celle-ci,

- au moins une zone frontière d'interpénétration des deux nappes conductrices, divisant chacune des deux nappes supérieure et inférieure en deux demi-nappes isolées entre elles de part et d'autre de la zone frontière, chacune des demi-nappes supérieure étant reliée, à l'intérieur de la zone frontière, à la demi-nappe inférieure située de l'autre côté de cette zone, de sorte que la surface du composant présente, de part et d'autre de la zone frontière, deux surfaces conductrices continues définissant chacune une borne du composant.

La double nappe assure une mise en parallèle optimale des cellules de chacun des deux types, grâce à l'absence de chute de tension significative. Ceci permet de multiplier le nombre de cellules en diminuant leur taille individuelle sans pour autant accroître les dimensions d'ensemble du composant : il n'en résulte - à la différence de toutes les solutions précédemment proposées - aucune chute de tension supplémentaire.

En outre, l'amenée de courant parfaitement homogène à toutes les cellules procure une excellente tenue en fréquence du composant, et assure par suite des temps de commutation extrêmement réduits.

La suppression des zones mortes d'amenée générale de courant procure de plus non seulement une économie de silicium, mais surtout améliore le fonctionnement du composant par suppression de l'injection parasite dans les zones mortes P, en évitant une dimension transversale excessive de la zone N (ou l'inverse).

Par ailleurs, la configuration de l'invention se prête très bien à un ballastage des zones d'émetteurs — et éventuellement des zones de bases — (ce ballastage consistant à interposer en série avec chaque émetteur une résistance, de manière à égaliser les courants de tous les émetteurs).

D'autre part, les paramètres thermiques sont grandement améliorés grâces aux liaisons très courtes entre chaque cellule et la nappe conductrice : d'une part les pertes dues aux chutes de tension sont réduites au minimum, et l'échauffement par effet Joule est minime ; d'autre part la chaleur produite au niveau de chaque jonction peut être dissipée efficacement dans la nappe conductrice, la liaison cellule-nappe étant très courte.

Enfin, le croisement des deux nappes permet de disposer d'un semi-conducteur présentant en surface deux (par exemple) grandes plages sur lesquelles peuvent aisément être réalisées les prises de connexion du semi-conducteur aux autres composants du circuit. Un tel cas se présente par exemple dans un montage inversé, consistant à retourner le composant semi-conducteur et le souder directement sur un substrat de circuit hybride. Une telle technique serait difficilement applicable avec un composant dont les prises de connexion se feraient latéralement et non par le dessus. En tout état de cause, l'amenée de courant au composant ne se ferait pas de façon aussi efficace que par les surfaces de grande étendue que possède le semi-conducteur de l'invention.

Plus précisément, la nappe inférieure est divisée en deux demi-nappes suivant un premier motif, et la nappe supérieure est divisée en deux demi-nappes par un second motif non superposé au précédent ; de cette manière, chaque paire de demi-nappes inférieure et supérieure respectivement situées de part et d'autre de la frontière présente au moins une zone où les demi-nappes sont en regard, zone entre laquelle est établie une liaison conductrice.

Avantageusement, le réseau que forment les cellules alternativement de types N et P est un réseau périodique dans au moins une direction parallèle à celle de la zone frontière ; dans ce cas, le premier motif est un motif régulier de pas égal à la maille du réseau et le second motif est un motif identique au premier, mais symétrique de celui-ci par rapport à la direction de la zone frontière.

De préférence, il est également prévu en surface une troisième couche isolante comprenant des plages dénudées de grandes dimensions aptes à former des prises de contact pour relier le composant à des circuits extérieurs.

Le procédé de fabrication de ce composant selon l'invention comprend les étapes suivantes :
. diffusion, en des endroits prédéterminés de la surface d'un substrat de type N ou P, d'une pluralité de zones

0125968

du type inverse, de manière à former un réseau ordonné de cellules alternativement de types N et P,

. dépôt sur ce substrat diffusé d'une première couche isolante,

. formation, dans la première couche isolante, d'ouvertures au droit de chacune des cellules N et P,

. dépôt d'une première couche conductrice, reliant ensemble toutes les cellules,

. dans cette première couche conductrice, détourage d'îlots à l'emplacement des ouvertures formées au droit de chacune des cellules d'un premier type, de manière à isoler ces îlots de la première couche conductrice, celle-ci ne reliant plus que les cellules du second type, la première couche conductrice étant en outre divisée le long d'au moins une zone frontière en deux demi-couches isolées entre elles par une première gorge pratiquée, suivant un premier motif, dans toute son épaisseur, et les types N ou P des cellules reliées ensemble au cours de cette étape et des suivantes étant inversés de part et d'autre de cette zone frontière,

. dépôt, sur la première couche, d'une seconde couche isolante,

. dénudation, dans cette seconde couche isolante, des sommets de chacun des îlots précédemment détourés, ainsi que d'ouvertures additionnelles le long de la zone frontière, de part et d'autre de la première gorge,

. dépôt d'une seconde couche conductrice, reliant ensemble les îlots,

. division, le long de la zone frontière, de cette seconde couche conductrice en deux demi-couches isolées entre elles, par une deuxième gorge pratiquée dans toute l'épaisseur de la seconde couche suivant un second motif

8 0125968

non superposé au premier motif, de façon que les paires
de demi-couches conductrices inférieure et supérieure
situées respectivement de part et d'autre de la frontière présentent chacune au moins une zone où les demi-
couches sont en regard, cette zone étant elle-même située
au droit de chacune des ouvertures additionnelles pratiquées dans la seconde couche isolante.

Avantageusement, il est prévu une étape finale de:
. dépôt d'une troisième couche isolante sur toute la
surface du composant,
. dénudation, dans cette troisième couche isolante, de
plages de grandes dimensions aptes à former ultérieurement prises de contact pour relier le composant à des
circuits extérieurs.

Bien qu'on décrive par la suite un transistor
bipolaire réalisé selon les enseignements de l'invention,
celle-ci n'est pas limitée à ce type de semi-conducteur et
s'applique aussi, notamment, aux semi-conducteurs déclenchés tels que les thyristors ou les triacs ; la cathode
et la gachette du semi-conducteur déclenché jouent alors
les mêmes rôles respectifs que l'émetteur et la base du
transistor.

Plus généralement, ce que propose l'invention
est un procédé de réalisation de prises de connexion intégrées, qui soit applicable chaque fois qu'il y a lieu
de mettre en parallèle deux séries de zones élémentaires
distinctes formées à la surface d'un substrat.

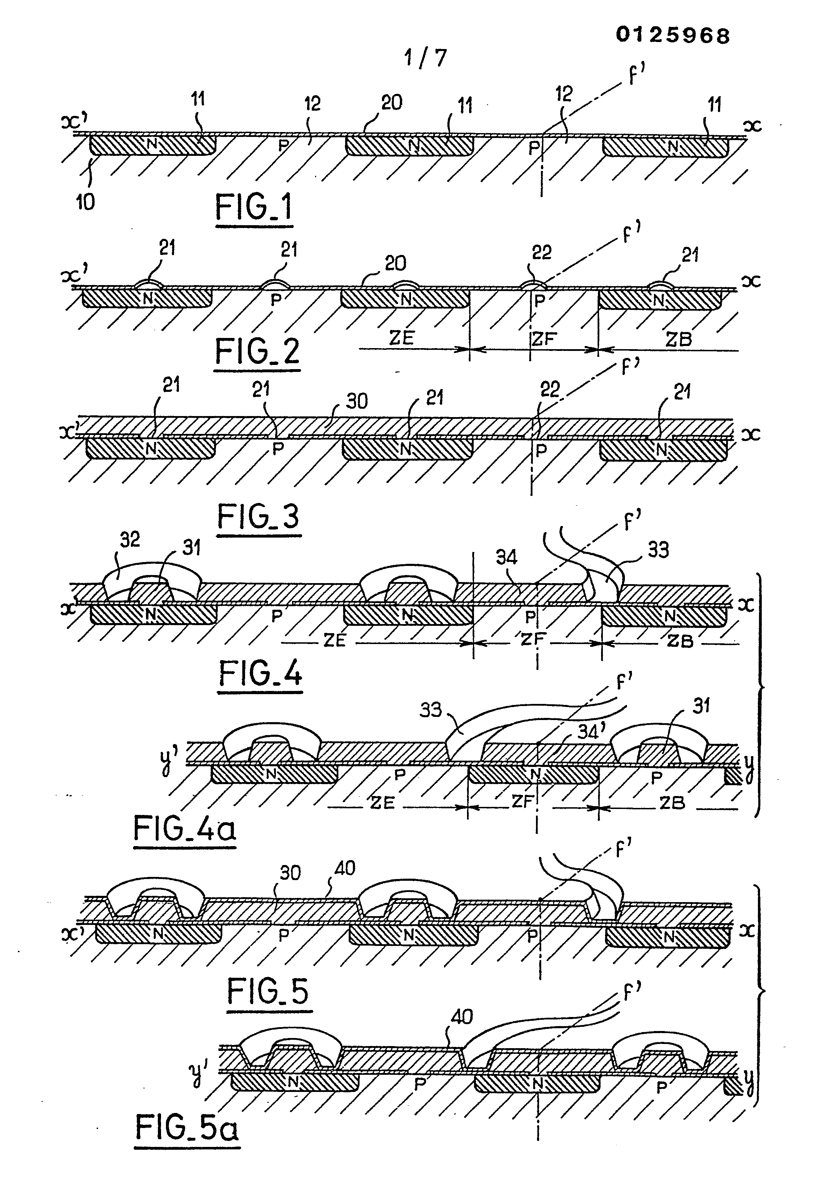

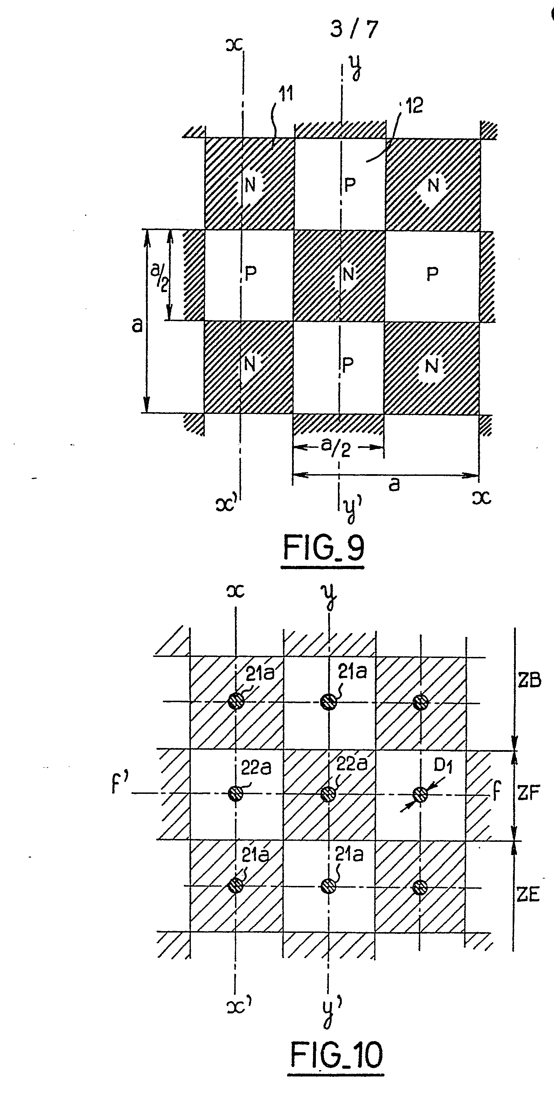

D'autres caractéristiques et avantages de
l'invention apparaîtront à la lecture de la description
détaillée ci-dessous, faite en référence aux dessins
annexés sur lesquels :
. les figures 1 à 8a illustrent les étapes du procédé de fabrication du composant selon l'invention ; elles représentent des coupes selon un plan vertical dont la trace est représentée sur les figures 9 à 13 par xx' (pour les figures 1 à 8) et yy' (pour les figures 4a à 8a),

. la figure 9 est une vue en plan du substrat du composant dans lequel sont diffusées les différentes zones semi-conductrices formant le réseau de cellules,

. les figures 10 à 13 représentent les différents masques utilisés successivement lors de la fabrication du composant,

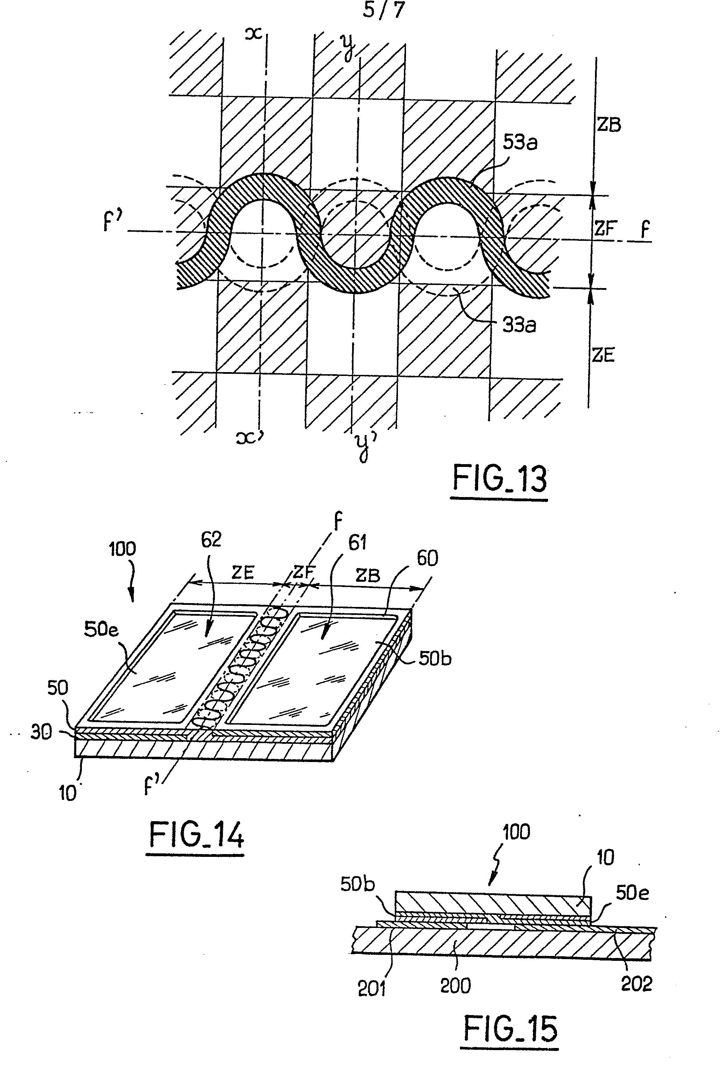

. la figure 14 est une vue perspective d'ensemble d'un composant achevé,

. la figure 15 est une vue en élévation de ce même composant retourné et monté inversé sur un substrat de circuit hybride,

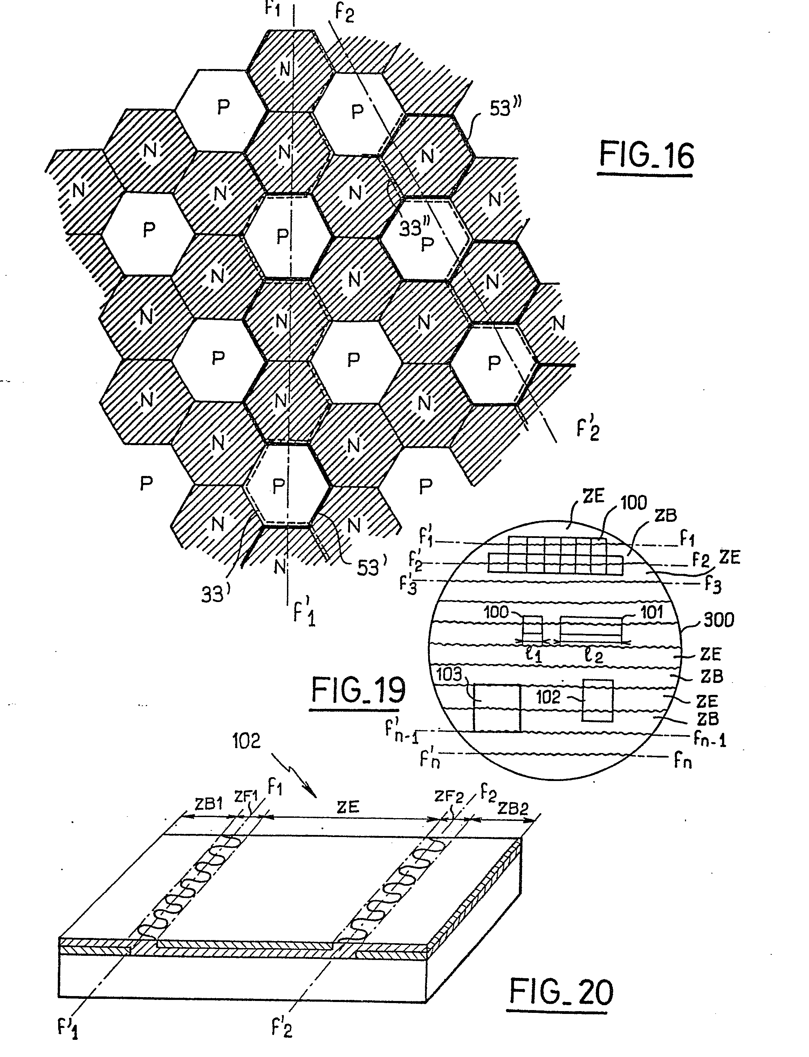

. les figures 16 à 18 sont des variantes de la figure 9, dans laquelle le réseau est organisé différemment,

. la figure 19 montre une plaquette de silicium à partir de laquelle sont fabriqués simultanément plusieurs composants,

. la figure 20 est une variante de la figure 14, qui représente un semi-conducteur à double zone frontière.

On décrira à titre d'exemple la fabrication d'un transistor bipolaire NPN selon l'invention : dans ce cas, comme on peut le voir sur la figure 1, le substrat 10 est un substrat de type P, dans lequel sont diffusées une pluralité de zones N référencées 11. Ces zones diffusées 11 et les zones 12 d'émergence du substrat sont réparties de manière à former un réseau de cellules individuelles alternativement de types N et P, comme on peut le voir sur la figure 9. Sur cette figure, on a représenté un réseau de cellules disposées de manière à former un damier de cellules carrées toutes de dimensions identiques (par convention, les zones non hachurées représentent les cellules de type P et les zones fortement hachurées représentent les cellules de type N). Le réseau ici décrit est donc un réseau périodique de maille a (soit deux fois le côté d'une cellule) dans deux directions orthogonales.

On peut par exemple choisir comme côté a/2 des cellules une valeur de l'ordre de 70 µm, le nombre des cellules étant déterminé en fonction de la puissance admissible du composant, par exemple un réseau d'environ 2000 cellules pour un transistor 10 A, ce qui correspond à une intensité de l'ordre de 5 mA par cellule individuelle.

Le choix d'un réseau régulier à cellules carrées n'est pas limitatif ; on peut envisager de nombreux réseaux, par exemple de bandes N et P alternées et juxtaposées, ou encore des réseaux en nid d'abeilles avec des cellules hexagonales (on en décrira plus loin un exemple en référence à la figure 16).

Le réseau est ensuite recouvert uniformément d'une couche isolante 20, par exemple de silice. Ensuite (figure 2), on pratique dans cette couche isolante une série d'ouvertures 21 ou 22 au droit de chacune des cellules du réseau. Dans l'exemple précité de cellules carrées de 70 µm de côté, ces ouvertures peuvent avoir par exemple un diamètre D1 de l'ordre de 10 µm.

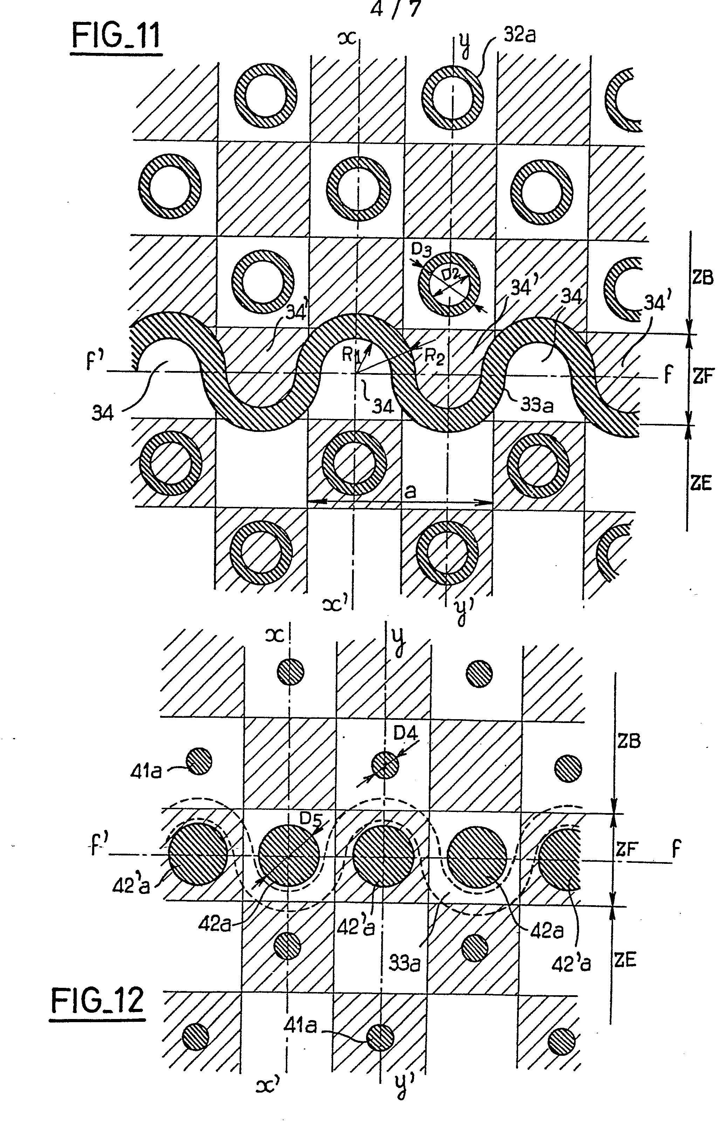

La figure 10 représente un masque permettant de réaliser ces ouvertures ; sur cette figure, comme sur les figures 11, 12 et 13, et par convention, les zones légèrement hachurées représenteront les zones du masque situées au droit des régions N du réseau (et bien que ces zones du masque soient des zones transparentes) et les zones non hachurées sont celles placées au droit des cellules P. Les motifs fortement hachurés correspondent, quant à eux, aux régions du substrat (ou des couches qui le recouvrent) qui seront attaquées par une méthode classique d'application d'une résine photosensible suivie d'une gravure chimique, par exemple.

Ces ouvertures pourront être pratiquées par exemple à partir de motifs ronds 21a ou 22a sur le masque.

La référence ZF correspond à une zone frontière définie de part et d'autre d'un axe f'f divisant le composant en deux régions ZB et ZE, dont on verra que, dans les opérations suivantes, les types N ou P des cellules reliées ensemble au cours d'une même opération sont inversés de la zone ZB à la zone ZE.

A cette étape du procédé, les deux régions ZB et ZE sont encore indifférenciées, toutes les cellules du réseau étant pourvues d'une ouverture 21a. En ce qui concerne la zone frontière ZF, il est très avantageux de pratiquer des ouvertures 22 au droit des cellules que cette zone couvre, en particulier dans la configuration représentée, où la zone frontière est une bande rectiligne ayant la largeur d'une cellule (c'est-à-dire une largeur égale à la demi-maille du réseau, ce qui procure l'inversion des types de cellules de part et d'autre de cette zone), on prévoit donc des ouvertures additionnelles 22 (correspondant aux motifs ronds 22a du masque) dans cette zone frontière au droit de chacune des cellules.

Dans une étape suivante (figure 3) on dépose une première couche conductrice 30 sur l'ensemble du composant ; cette première couche (qui sera également désignée par la suite "nappe inférieure" ou "couche inférieure") relie donc ensemble toutes les cellules du réseau par l'intermédiaire des ouvertures 21 ou 22 précédemment pratiquées. Cette première couche conductrice peut être par exemple une couche d'aluminium.

Dans une étape suivante du procédé, illustrée figures 4 et 4a (la figure 4 représente une coupe selon x'x et la figure 4a selon y'y, ces deux coupes étant décalées transversalement d'une demi-période de réseau), on pratique une gravure de la couche inférieure.

En premier lieu, on isole des pions 31 au droit de chaque cellule N dans la région ZE, et au droit de chaque cellule P dans la région ZB. Ce détourage des pions ou îlots 31 est obtenu par formation d'une gorge circulaire 32 par exemple de diamètre D2 intérieur 20 μm et de diamètre D3 extérieur 50 μm; cette gorge est creusée dans toute l'épaisseur de la première couche conductrice jusqu'à atteindre la couche isolante 20. De cette manière, dans la zone ZE, toutes les cellules P sont réunies électriquement ensemble par cette première couche, toutes les cellules N étant isolées (et inversement pour la zone ZB).

Ce détourage des îlots 31 est obtenu grâce au masque de la figure 11, qui comporte des zones opaques 32a en forme de couronne placées au droit des zones P dans la région ZB, et au droit des zones N dans la région ZE.

En second lieu, au cours de cette même étape du procédé, on forme une gorge 33 continue divisant la première couche conductrice le long de la zone frontière ZF en deux demi-couches isolées entre elles et recouvrant chacune respectivement les zones ZE et ZB.

Cette gorge n'est pas rectiligne ; elle a au contraire une forme sinueuse périodique, dont la période $a$ est de préférence égale à la maille du réseau, c'est-à-dire qu'une sinuosité du motif a pour période la largeur de deux cellules, dans le cas de l'exemple décrit.

Sur les figures, la gorge 33 (qui correspond au motif 33a du masque de la figure 11) a une forme pseudo-sinusoïdale, en fait formée de demi-couronnes alternées ayant chacune un rayon intérieur R1 de l'ordre de 25 µm et un diamètre extérieur R2 de l'ordre de 45 µm.

En pratique, la forme précise du motif 33a est sans importance, et toute forme sinueuse, arrondie ou anguleuse, peut convenir. La condition essentielle est que ce motif définisse dans la première couche conductrice, le long de l'axe f'f de la zone frontière, une alternance de zones saillantes 34, 34' qui appartiennent alternativement à l'une ou l'autre des deux demi-couches (les zones 34 appartiennent à la demi-couche de la zone ZE, et sont donc en contact avec toutes les zones P - qui seront les bases du transistor - de cette zone ; de même, les zones 34' appartiennent à la demi-couche de la zone ZB, et sont donc reliées à toutes les cellules N de cette zone - qui deviendront les émetteurs du transistor).

L'étape suivante du procédé (figures 5 et 5a) consiste, après avoir gravé la première couche 30 comme indiqué précédemment, à recouvrir celle-ci uniformément d'une couche isolante 40, par exemple de silice.

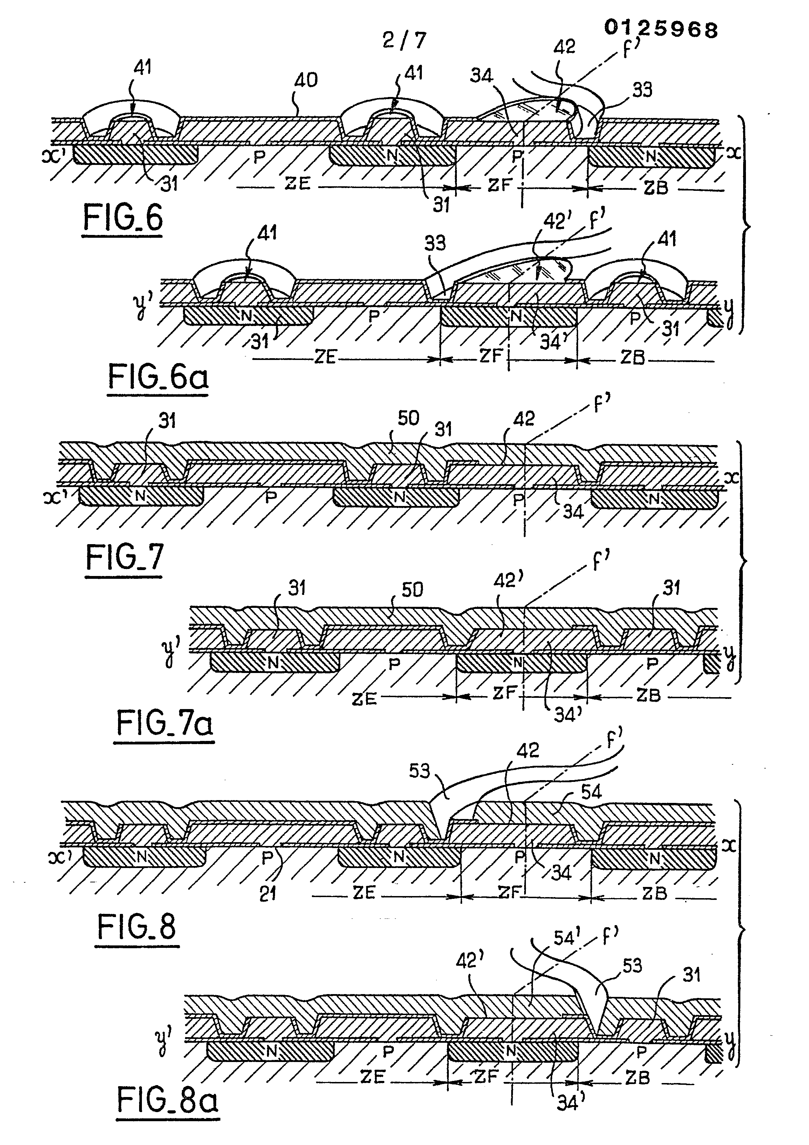

Au cours de l'étape suivante (illustrée figures 6 et 6a), on dénude les sommets 41 de chacun des îlots 31 précédemment détourés par attaque de la couche isolante 40 à l'endroit de ces îlots. Au cours de cette même étape, on dénude également des ouvertures additionnelles 42, 42' le long de la zone frontière ZF, de part et d'autre de la gorge 33 précédemment réalisée. Les ouvertures référencées 42 correspondent à des parties saillantes de la demi-nappe inférieure s'étendant sur la zone ZE ; les ouvertures référencées 42' correspondent à des parties saillantes de la demi-nappe inférieure s'étendant sur la zone ZB.

La figure 12 montre un exemple de masque approprié pour réaliser cette opération de dénudation : les zones opaques 41a, d'un diamètre D4 de l'ordre de 20 μm dans l'exemple cité, permettent de réaliser la mise à nu des îlots assurant la prise de contact sur les cellules N (qui seront les émetteurs du transistor) dans la région ZE, et la prise de contact sur les cellules P (qui seront les bases du transistor) dans la région ZB. Les zones opaques 42a et 42'a, d'un diamètre D5 d'environ 40 μm, correspondent aux ouvertures respectives 42 et 42' pratiquées alternativement sur la nappe inférieure s'étendant dans la région ZE et sur la nappe inférieure s'étendant dans la région ZB (la référence 33a figure la position de la première gorge pratiquée dans la nappe inférieure).

On dépose ensuite (figures 7 et 7a) une seconde couche conductrice 50 uniformément sur l'ensemble du composant ; cette seconde couche (qui sera appelée par la suite "couche supérieure" ou "nappe supérieure") relie donc électriquement ensemble tous les îlots 31 du composant et toutes les ouvertures additionnelles 42, 42' précédemment pratiquées.

La dernière étape du procédé (figures 8 et 8a) consiste à diviser cette seconde couche conductrice, le long de la zone frontière ZF, par une deuxième gorge 53 pratiquée dans toute son épaisseur. Cette gorge divise donc la nappe supérieure en deux demi-nappes isolées entre elles. La gorge 53 est réalisée suivant un motif non superposé au premier motif ; de la sorte, les paires de demi-couches conductrices inférieure et supérieure situées respectivement de part et d'autre de la zone frontière présentent chacune au moins une zone en regard au droit des ouvertures additionnelles précédemment pratiquées. Par exemple, sur la figure 8, la demi-nappe inférieure s'étendant dans la zone ZE présente une partie saillante 34 en regard, au droit de l'ouverture 42, avec une autre partie saillante 54 de la demi-couche supérieure s'étendant dans la zone ZB. De la sorte, ces deux demi-couches sont électriquement reliées ensemble. Si l'on se souvient que la demi-couche inférieure s'étendant dans la zone ZE relie ensemble toutes les cellules P de cette zone par les ouvertures 21 et que la demi-couche supérieure s'étendant dans la zone ZB relie ensemble toutes les cellules P de cette zone par l'intermédiaire des îlots 31, on voit ainsi que toutes les cellules P du composant (y compris les cellules situées au droit des ouvertures 42) sont reliées ensemble en parallèle et à la demi-nappe supérieure de la zone ZB : cette demi-nappe formera ainsi l'électrode de base du composant.

On peut tenir le raisonnement symétrique pour la demi-nappe supérieure de la zone ZE, qui constituera l'électrode d'émetteur du composant en reliant ensemble toutes les cellules N du réseau : cette demi-nappe supérieure comporte en effet des parties saillantes 54' qui sont en contact avec les parties saillantes 34' de la demi-nappe inférieure s'étendant dans la zone ZB qui, pour sa part, est en contact avec toutes les cellules N de cette zone ; on notera également que toutes les cellules N situées au droit des ouvertures 42' sont reliées à cette liaison conductrice.

La figure 13 montre un exemple de masque permettant de réaliser la seconde gorge 53 : on remarque que le motif 53a correspondant est le symétrique du motif 33a ayant servi à réaliser la première gorge, par rapport à l'axe f'f de la zone frontière.

Le composant 100 finalement obtenu, représenté schématiquement figure 14, comporte donc, de part et d'autre de la zone frontière ZF qui le divise en deux moitiés ZE et ZB, une surface supérieure (la seconde nappe conductrice 50) divisée en deux grandes plages 50e et 50b formant respectivement l'électrode d'émetteur et l'électrode de base du composant. L'électrode 50e est reliée à l'ensemble des cellules N du réseau (y compris celles situées dans les zones ZF et ZB) et l'électrode 50b est reliée à l'ensemble des cellules P du réseau (y compris celles situées dans les zones ZF et ZE); ceci grâce au croisement des deux nappes dans la zone frontière ZF. Comme on peut le constater, la structure proposée permet d'assurer une interpénétration des deux nappes dans cette zone sans aucun allongement de trajet du courant (à la différence des structures interdigitées) donc sans chute de tension notable.

De préférence, on dépose sur toute la surface du composant une troisième couche isolante 60 (représenté figure 14) dans laquelle on dénude ensuite des plages 61, 62 de grandes dimensions laissant apparaître les surfaces 50e, 50b de prise de contact sur la deuxième couche conductrice seulement aux endroits qui recevront par la suite les soudures (par exemple) reliant le composant aux circuits extérieurs. Les zones non soudées de la deuxième couche conductrice sont ainsi protégées vis-à-vis de l'environnement.

Par ailleurs, la structure finale avec deux grandes plages assurant la prise de connexion permet le montage inversé du composant sur un substrat de circuit hybride ; ce montage est représenté figure 15 : le composant 100 de la figure 14 a été retourné : le substrat 10 est donc tourné vers le haut et les deux plages 50e et 50b sont connectées à des motifs 201 et 202 formés sur le substrat 200 d'un circuit hybride. Ceci permet de réaliser une prise de connexion sur pratiquement toute la surface de chacune des deux plages 50e et 50b (c'est-à-dire sur environ la moitié de la surface totale du composant) ; l'amenée de courant au composant peut donc se faire de façon optimale en minimisant les chutes de tension à cet endroit.

On a indiqué plus haut que le réseau en forme de damier qui a fait l'objet de l'exemple décrit n'était pas le seul envisageable; la figure 16 décrit un autre exemple où les cellules sont hexagonales et forment un réseau en nid d'abeilles . Sur l'exemple illustré , chaque cellule P est entourée de six cellules N. Il y a ainsi dans le réseau deux fois plus de cellules N que de cellules P : on peut ainsi privilégier un type de cellule par rapport à l'autre, ce qui est intéressant notamment lorsque le transistor est utilisé en amplification de puissance. En effet, dans ce cas, le courant moyen d'émetteur est toujours supérieur au courant moyen de base et il est donc souhaitable de privilégier l'émetteur par rapport à la base. Au contraire, pour un semi-conducteur utilisé en commutation, le courant moyen de base est sensiblement du même ordre que le courant moyen d'émetteur, ce qui correspond de préférence à un réseau où les émetteurs et les bases sont indifférenciés, par exemple le réseau en damier précédemment décrit, ou un réseau en forme de bandes identiques .

Dans la configuration de la figure 16, la maille du réseau dans la direction $f'_1 f_1$ est de trois cellules : les motifs correspondant aux gorges divisant chacune des demi-nappes ont donc une périodicité égale à cette valeur ; ils ont été figurés en 33' pour le motif divisant la nappe inférieure et en 53' pour celui divisant la nappe supérieure. On remarquera que ces deux motifs sont symétriques par rapport à l'axe $f'_1$ $f_1$ ; cependant, comme précédemment, il n'est pas nécessaire que la symétrie soit totale ; le point essentiel est la présence de parties saillantes en regard sur chacune des nappes. La configuration proposée assure cependant des chutes de tension minimales à l'emplacement où les deux nappes s'interpénètrent .

On notera que, dans le cas du réseau hexagonal, on peut définir une seconde frontière selon la ligne $f'_2 f_2$ avec des motifs correspondants 33" et 53"; on notera cependant que le pas de ces motifs est de deux cellules et qu'ils ne sont pas symétriques entre eux, ce qui est dû au fait qu'il y aura dans la zone frontière correspondante autant de cellules N que de cellules P, à la différence du cas précédent, où l'on a deux cellules N pour une cellule P, (ce qui correspond aux proportions de l'ensemble du réseau).

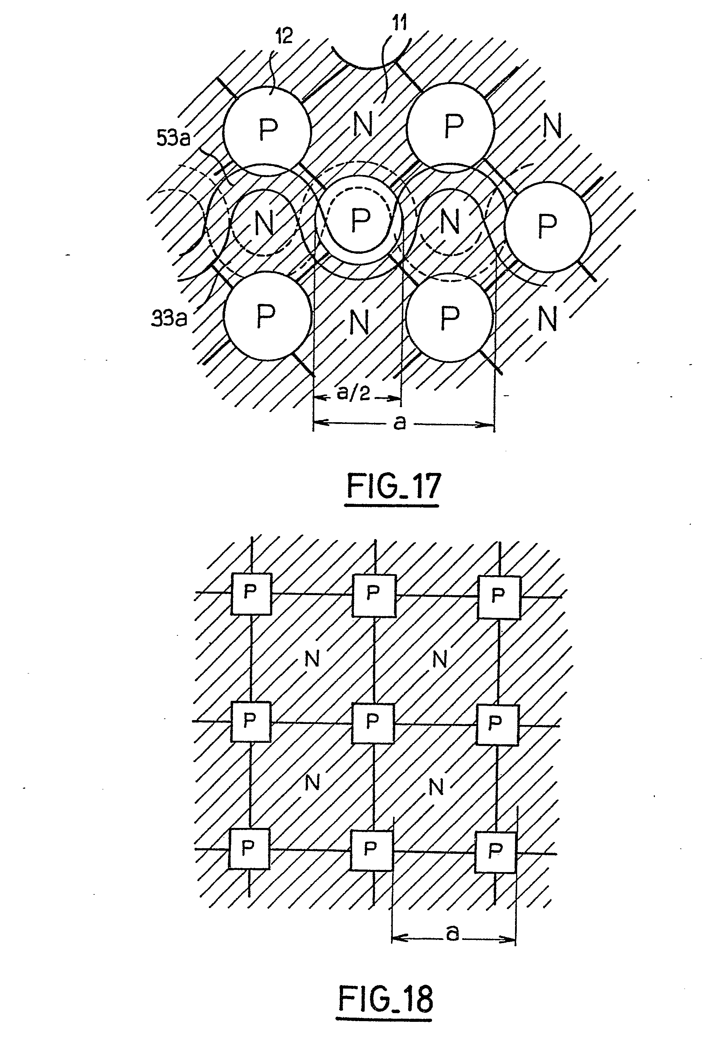

La figure 17 représente une variante du réseau de la figure 9, dans laquelle les zones 12 de type P (zones de bases) ne sont plus carrées, mais circulaires de diamètre a/2. Cette configuration est géométriquement plus intéressante, mais surtout permet d'avoir une surface totale des émetteurs supérieure à celle des bases, avec les mêmes avantages que ceux précédemment cités à propos du réseau hexagonal.

On notera que, dans ce cas, les gorges 33a et 53a divisant chaque nappe en deux demi-nappes peuvent être réalisées suivant le même motif que celui décrit pour le réseau de la figure 9.

La figure 18 représente une autre variante de réseau où les cellules N sont encore privilégiées par rapport aux cellules P, formées de carrés plus petits.

Un autre avantage de la structure de l'invention est qu'elle permet d'obtenir des composants de calibres (intensités maximales admissibles) différents sans modification des masques de tirage et à partir d'un unique lot de diffusion .

En effet, de manière classique, les semi-conducteurs sont réalisés en grand nombre sur une plaquette unique 300 de silicium (représentée schématiquement figure 19) qui est ensuite découpée en composants individuels. Pour réaliser les composants de l'invention, on définit sur cette plaquette une pluralité de zones frontières $f'_1 f_1$, $f'_2 f_2$, .... $f'_{n-1} f_{n-1}$, $f'_n f_n$. Si l'on réalise les étapes du procédé, la nappe supérieure recouvrant l'ensemble de la plaquette sera divisée en une alternance de zones d'émetteur ZE et de zones de base ZB. On pourra ensuite découper dans ces zones, de part et d'autre de chacune des zones frontières, des composants individuels tels que 100 ou 103.

Un des avantages procurés par l'invention est la possibilité de choisir, au moment du découpage de la plaquette, le calibre du composant individuel par un simple choix de la longueur de la zone découpée : ainsi, si le composant 100, de longueur $\ell_1$, à un calibre de 5 A, il suffira de découper un composant 101 de longueur $\ell_2$ double ou triple si l'on veut obtenir un composant de calibre 10 ou 15 A, par exemple. Cette augmentation de calibre est permise par le fait que le nombre de cellules du réseau est proportionnel à la taille du composant et qu'il suffit d'en augmenter le nombre · pour en augmenter le calibre (ce qui n'est pas le cas avec les structures interdigitées dont la complexité croît beaucoup plus vite que la taille).

Sur la même plaquette 300, il est également possible de découper un composant tel que 102 comportant une pluralité de zones frontières, par exemple deux. Ce composant, représenté plus en détail figure 20, présente en surface une zone d'émetteur central ZE bordée par deux zones de base $ZB_1$ et $ZB_2$. Les deux nappes inférieure et supérieure s'interpénètrent donc et se croisent deux fois, dans les zones $ZF_1$ et $ZF_2$. Cette structure est avantageuse pour les semi-conducteurs de très forte puissance à "double base".

On voit ainsi qu'avec un seul lot de diffusion il est possible d'obtenir, par simple choix des dimensions de découpe, toute une gamme de composants. Au contraire, dans les structures de la technique antérieure, il était nécessaire dès le départ de définir le calibre souhaité, donc la dimension du composant, et de réaliser un jeu de masques spécifiques pour chaque calibre.

En variante, on peut prévoir sur la plaquette 300 des bandes ZE et ZB de largeurs respectives différentes, ce qui amènera après découpage du composant à des zones de contact de base et d'émetteurs de dimensions différentes. Cette variante est applicable notamment lorsque l'on souhaite privilégier un type d'électrode par rapport à l'autre.

REVENDICATIONS

1. Un composant semi-conducteur de puissance, du type comprenant une pluralité de zones (11) de type N ou P diffusées à la surface d'un substrat (10) de type respectivement P ou N de manière à présenter, en surface du substrat, une pluralité de zones diffusées (11) et de zones d'émergence (12) du substrat ordonnées les unes par rapport aux autres pour former un réseau de cellules alternativement de types N et P, les cellules de chaque type étant toutes reliées entre elles et à un conducteur commun définissant l'une des bornes du composant, caractérisé en ce qu'il comprend également :

. une nappe conductrice inférieure (30) formant un premier conducteur commun, s'étendant au-dessus de la surface du substrat et isolée de celui-ci à l'exception de ponts (21) reliant cette nappe à chacune des cellules d'un premier type, N ou P,

. une nappe conductrice supérieure (50) formant un second conducteur commun, s'étendant au-dessus de la nappe inférieure et isolée de celle-ci, cette nappe supérieure étant reliée à chacune des cellules du second type, P ou N respectivement, au moyen de ponts conducteurs (31) traversant, au droit de chacune des cellules, la nappe inférieure en restant isolés de cette nappe et sans solution de continuité électrique de celle-ci,

. au moins une zone frontière (ZF) d'interpénétration des deux nappes conductrices, divisant chacune des deux nappes supérieure et inférieure en deux demi-nappes isolées entre elles de part et d'autre de la zone frontière, chacune des demi-nappes supérieure étant reliée, à l'intérieur de la zone frontière, à la demi-nappe inférieure située de l'autre côté de cette zone, de sorte que la surface du composant présente, de part et d'autre de la zone frontière, deux surfaces conductrices continues (50e, 50b) définissant chacune une borne du composant.

2. Composant selon la revendication 1, caractérisé en ce que, la nappe inférieure étant divisée en deux demi-nappes suivant un premier motif (33), la nappe supérieure est divisée en deux demi-nappes par un second motif (53) non superposé au précédent, de manière que chaque paire de demi-nappes inférieure et supérieure respectivement situées de part et d'autre de la frontière présente au moins une zone (34, 54 ; 34', 54') où les demi-nappes sont en regard, zone entre laquelle est établie une liaison conductrice.

3. Composant selon la revendication 2, dans lequel le réseau est un réseau périodique dans au moins une direction parallèle à celle de la zone frontière, caractérisé en ce que le premier motif est un motif régulier de pas égal à la maille (a) du réseau et en ce que le second motif est un motif identique au premier, mais symétrique de celui-ci par rapport à la direction (f'f) de la zone frontière.

4. Composant selon la revendication 3, caractérisé en ce que les zones (34, 54 ; 34', 54') en regard des demi-nappes inférieure et supérieure situées de part et d'autre de la frontière, et entre lesquelles est établie une liaison conductrice, sont également reliées à chaque cellule de la zone frontière au droit desquelles elles se trouvent, ces cellules étant du même type que celles reliées par le conducteur commun formé par les deux demi-nappes reliées à cet endroit.

5. Composant selon l'une des revendications 1 à 4, caractérisé en ce qu'il comprend en surface une troisième couche isolante comprenant des plages dénudées de grandes dimensions aptes à former prises de contact pour relier le composant à des circuits extérieurs.

6. Un procédé de fabrication d'un composant selon l'une des revendications précédentes, comprenant les étapes de :

. diffusion, en des endroits prédéterminés de la surface d'un substrat (10) de type N ou P, d'une pluralité de zones (11) du type inverse, de manière à former un réseau ordonné de cellules (11, 12) alternativement de typesN et P,

. dépôt sur ce substrat diffusé d'une première couche isolante (20),

caractérisé en ce qu'il comprend, ensuite, les étapes de :

. formation, dans la première couche isolante, d'ouvertures (21) au droit de chacune des cellules N et P,

. dépôt d'une première couche conductrice (30), reliant ensemble toutes les cellules,

. dans cette première couche conductrice, détourage d'îlots (31) à l'emplacement des ouvertures (21) formées au droit de chacune des cellules d'un premier type, de manière à isoler ces îlots de la première couche conductrice, celle-ci ne reliant plus que les cellules du second type, la première couche conductrice étant en outre divisée le long d'au moins une zone frontière (ZF) en deux demi-couches isolées entre elles par une première gorge (33) pratiquée, suivant un premier motif, dans toute son épaisseur, et les types N ou P des cellules reliées ensemble au cours de cette étape et des suivantes étant inversés de part et d'autre de cette zone frontière,

. dépôt, sur la première couche conductrice d'une seconde couche isolante (40),

. dénudation, dans cette seconde couche isolante, des sommets (41) de chacun des îlots précédemment détourés, ainsi que d'ouvertures additionnelles (42, 42') le long de la zone frontière, de part et d'autre de la première gorge,

. dépôt d'une seconde couche conductrice (50), reliant ensemble les îlots,

. division, le long de la zone frontière, de cette seconde couche conductrice en deux demi-couches isolées entre elles, par une deuxième gorge (53) pratiquée dans toute l'épaisseur de la seconde couche suivant un second motif non superposé au premier motif, de façon que les paires de demi-couches conductrices inférieure et supérieure situées respectivement de part et d'autre de la frontière présentent chacune au moins (34, 54 ; 34', 54') une zone où les demi-couches sont en regard, cette zone étant elle-même située au droit de chacune des ouvertures additionnelles (42, 42') pratiquées dans la seconde couche isolante.

7. Un procédé selon la revendication 6, pour la fabrication d'un composant selon la revendication 4, caractérisé en ce que, lors de l'étape de formation d'ouvertures dans la première couche isolante, on forme également des ouvertures additionnelles dans la zone frontière au droit de chacune des cellules de cette zone qui sont du même type que celles reliées par les demi-couches conductrices dont les zones en regard sont situées au droit de cette cellule.

8. Un procédé selon l'une des revendications 6 et 7, caractérisé en ce qu'il comporte une étape finale de :

. dépôt d'une troisième couche isolante sur toute la surface du composant,

. dénudation, dans cette troisième couche isolante, de plages de grandes dimensions aptes à former ultérieurement prises de contact pour relier le composant à des circuits extérieurs.

0125968

FIG_1

FIG_2

FIG_3

FIG_4

FIG_4a

FIG_5

FIG_5a

FIG.6

FIG.6a

FIG_7

FIG_7a

FIG_8

FIG_8a

## FIG.9

## FIG.10

FIG_11

FIG_12

0125968

**FIG_13**

**FIG_14**

**FIG_15**

**FIG. 16**

**FIG. 19**

**FIG. 20**

FIG_17

FIG_18

**RAPPORT DE RECHERCHE EUROPEENNE**

Office européen
des brevets

**0125968**

Numéro de la demande

EP 84 40 0875

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | US-A-3 704 398 (NIPPON ELECTRIC CO.)<br><br>----- | | H 01 L 29/08<br>H 01 L 29/52 |

DOMAINES TECHNIQUES
RECHERCHES (Int. Cl. ³)

H 01 L 29

Le présent rapport de recherche a été établi pour toutes les revendications

| Lieu de la recherche | Date d'achèvement de la recherche | Examinateur |
|---|---|---|
| LA HAYE | 10-08-1984 | PELSERS L. |